# EUROPÄISCHE PATENTSCHRIFT

(11) **EP 2 999 605 B1**
(45) Veröffentlichungstag und Bekanntmachung des Hinweises auf die Patenterteilung: **19.02.2020**
(21) Anmeldenummer: 14726902.1
(22) Anmeldetag: 09.05.2014
(51) Int. Cl.: H01M 10/42, H01M 10/48

(54) **VERFAHREN UND VORRICHTUNGEN ZUM BEREITSTELLEN VON INFORMATIONEN ZU WARTUNGS- UND SERVICEZWECKEN EINER BATTERIE**
METHOD AND DEVICES FOR PROVIDING INFORMATION FOR THE PURPOSES OF MAINTAINING AND SERVICING A BATTERY
PROCÉDÉ ET DISPOSITIFS DE FOURNITURE D'INFORMATIONS À DES FINS DE MAINTENANCE ET D'ENTRETIEN D'UNE BATTERIE

(30) Priorität: 22.05.2013 DE 102013209446
(43) Veröffentlichungstag der Anmeldung: 30.03.2016
(73) Patentinhaber: Robert Bosch GmbH, 70442 Stuttgart (DE); Samsung SDI Co., Ltd., Yongin-si, Gyeonggi-do 446-577 (KR)
(72) Erfinder: BROCHHAUS, Christoph, 52072 Aachen (DE)
(74) Vertreter: Bee, Joachim
(86) Internationale Anmeldenummer: PCT/EP2014/059512
(87) Internationale Veröffentlichungsnummer: WO 2014/187681

(56) Entgegenhaltungen:
- DE-A1-102010 031 337
- US-A1- 2009 115 653
- US-A1- 2011 089 953

## Beschreibung

### Stand der Technik

Die Erfindung betrifft ein Verfahren zum Bereitstellen von Informationen zu Wartungs- und Servicezwecken einer Batterie, die mehrere Batterieeinheiten umfasst, wobei Nutzungsdaten der Batterieeinheiten erfasst und quantisiert werden und wobei Histogramme gebildet werden, die Häufigkeitswerte des Auftretens bestimmter Werte der einzelnen quantisierten Nutzungsdaten oder daraus abgeleitete Werte aufweisen.

Die Erfindung betrifft außerdem ein Verfahren, welches die Informationen auf dezentralen Modulsteuergeräten bereitstellt.

Weiterhin wird eine Datenstruktur mit derartigen Informationen angegeben, sowie ein Computerprogramm und ein Batteriemanagementsystem, die insbesondere zur Durchführung der Verfahren eingerichtet sind. Weiterhin werden eine Batterie und ein Kraftfahrzeug mit einer derartigen Batterie angegeben.

Elektronische Steuergeräte werden im automobilen Umfeld heutzutage in zunehmender Zahl eingesetzt, Beispiele hierfür sind Motorsteuergeräte oder Steuergeräte für ABS oder den Airbag. Für elektrisch angetriebene Fahrzeuge ist ein heutiger Forschungsschwerpunkt die Entwicklung von leistungsfähigen Batteriepacks mit zugehörigen Batteriemanagementsystemen, d.h. Steuergeräten, welche mit einer Software zur Überwachung der Batteriefunktionalität ausgestattet sind. Batteriemanagementsysteme gewährleisten unter anderem die sichere und zuverlässige Funktion der eingesetzten Batteriezellen und Batteriepacks. Sie überwachen und steuern Ströme, Spannungen, Temperaturen, Isolationswiderstände und weitere Größen für einzelne Zellen und/oder den ganzen Batteriepack. Mit Hilfe dieser Größen lassen sich Managementfunktionen realisieren, die die Lebensdauer, Zuverlässigkeit und Sicherheit des Batteriesystems steigern.

DE 10 2010 031 337 A1 zeigt ein Verfahren zur Ermittlung der voraussichtlichen Lebensdauer von Batteriezellen. Dabei werden physikalische Größen und/oder die Anzahl von Durchführungen von in den Batteriezellen stattfindenden Vorgängen für mehrere Betriebszyklen ermittelt und die Häufigkeit des Auftretens bestimmter Werte der physikalischen Größe und/oder die Häufigkeit der Anzahl der Durchführungen wenigstens eines bestimmten Vorgangs gespeichert. Hierdurch lassen sich unter anderem Zelldefekte frühzeitig erkennen, verhindern und genaue Erkenntnisse hinsichtlich der voraussichtlichen Lebensdauer der Batteriezelle gewinnen.

US 5,552,999 zeigt ein Verfahren zur Überwachung eines Leistungsverbrauchs einer Batterie in einem Batteriepack, wobei ein Histogramm generiert wird.

US 2011/0089953 zeigt ein Verfahren zum Speichern von validierten Batteriedaten in einem Histogramm.

### Offenbarung der Erfindung

Nach einem ersten Aspekt umfasst ein erfindungsgemäßes Verfahren zum Bereitstellen von Informationen zu Wartungs- und Servicezwecken einer Batterie, die ein Steuergerät mit einem nicht-flüchtigen Speicher und mehrere Batterieeinheiten aufweist, die folgenden Schritte:
a) Erfassen und Quantisieren von Nutzungsdaten der Batterieeinheiten;
b) Bilden eines Histogramms, das Häufigkeitswerte des Auftretens bestimmter Werte der einzelnen quantisierten Nutzungsdaten oder daraus abgeleitete Werte aufweist;
c) Ermitteln zumindest eines zusätzlichen Informationsträgers, der zu einer Validitätsprüfung des Histogramms eingerichtet ist, in Form einer Prüfsumme, die mittels einer Einwegfunktion berechnet wird; und
d) Speichern des Histogramms und des zusätzlichen Informationsträgers in den nicht-flüchtigen Speicher des Steuergeräts.

Das Verfahren kann Anwendung finden bei Batterien, die ein zentrales Steuergerät mit einem nicht-flüchtigen Speicher aufweisen. Insbesondere die Verfahrensschritte c) und d) werden dabei bevorzugt von dem zentralen Steuergerät ausgeführt. Das Verfahren kann auch bei Batterien Anwendung finden, die zumindest ein Batteriemodul mit einem zugeordneten Modulsteuergerät mit einem nicht-flüchtigen Speicher aufweisen. Insbesondere die Verfahrensschritte c) und d) werden dabei bevorzugt von dem Modulsteuergerät ausgeführt. Besonders bevorzugt ist vorgesehen, dass die Schritte c) und d) sowohl von dem zentralen Steuergerät, als auch von den Modulsteuergeräten ausgeführt werden.

Nach einem weiteren Aspekt umfasst ein erfindungsgemäßes Verfahren zum Bereitstellen von Informationen zu Wartungs- und Servicezwecken einer Batterie, die zumindest ein Batteriemodul mit einem zugeordneten Modulsteuergerät und ein zentrales Steuergerät umfasst, wobei zumindest ein Modulsteuergerät einen nicht-flüchtigen Speicher aufweist, die folgenden zusätzlichen Schritte:
iv) Übermitteln des Histogramms und des zumindest einen zusätzlichen Informationsträgers von dem zentralen Steuergerät an ein Modulsteuergerät;
v) Validieren des Histogramms anhand des zumindest einen zusätzlichen Informationsträgers durch das Modulsteuergerät;
vi) Speichern des Histogramms in den nicht-flüchtigen Speicher des Modulsteuergeräts. Vorteilhaft wird bei den erfindungsgemäßen Verfahren eine Historie über die Nutzung der Batterie geführt, welche sowohl im Rahmen von Gewährleistungsansprüchen als auch zur Auswertung der Nutzung der Batterie, beispielsweise zur Ermittlung der voraussichtlichen Lebensdauer oder des Gesundheitszustands (SOH) der Batterieeinheit ausgelesen und herangezogen kann. Dabei werden Histogramme gebildet, wobei die Histogramme den einzelnen quantisierten Nutzungsdaten zuordnungsfähige Anzahlen von Erfassungen des jeweiligen quantisierten Nutzungsdatums oder daraus abgeleitete Werte aufweisen. Die Histogramme eignen sich besonders vorteilhaft zur Ermittlung der Lebensdauer und des Gesundheits- und Alterungszustands der Batterieeinheit. Durch Verwendung eines Zählers für die Fahrzyklen können außerdem Rückschlüsse auf die durchschnittliche Nutzung der Batterieeinheit pro Fahrzyklus gezogen werden. Somit gibt das Histogramm einen Gesamtüberblick über die Verwendung der Batterie während der bisherigen Lebensdauer. Auch im Rahmen von Gewährleistungsansprüchen kann das Histogramm aus dem nichtflüchtigen Speicher des betreffenden Steuergeräts ausgelesen und zur Auswertung der Nutzung der Batterie herangezogen werden.

Die Aktualisierung des Histogramms erfolgt nach jedem Fahrzyklus. Ein Histogramm umfasst somit die Häufigkeitswerte des Auftretens bestimmter Werte der einzelnen quantisierten Nutzungsdaten des letzten Fahrzyklus und der vorherigen Fahrzyklen. Die einen Beginn und ein Ende des Fahrzyklus auslösenden Ereignisse können beispielsweise Ladeimpulse sein, ein Zustandswechsel der Batterie von "Betrieb" (Drive) nach "Laden" (Charge), eine Auswertung eines Signals "Laden aktiv" oder auch eine Auswertung eines Zustandswechsels an Klemme 15, d. h. des Zündungsplus. Ebenso kann das den Beginn und das Ende des Fahrzyklus auslösende Ereignis durch eine Detektion des so genannten Batteriebalancing definiert sein. Der Fahrzyklus kann beispielsweise definiert werden, dass er einen daran anschließenden Ladevorgang mit umfasst oder diesen nicht mit umfasst.

Vor, während oder nach dem Fahrzyklus wird ein bestehendes Histogramm aus dem nicht-flüchtigen Speicher des Steuergeräts geladen. Während des Fahrzyklus wird ein aktuelles Histogramm bevorzugt im flüchtigen Speicher des Steuergeräts erstellt. Nach dem Fahrzyklus werden das aktuelle Histogramm und das bestehende Histogramm zu einem aktualisierten Histogramm zusammengefügt und in den nicht-flüchtigen Speicher des Steuergeräts gespeichert. Ein solcher nichtflüchtiger Speicher ist z.B. ein so genannter EEPROM, d.h. ein elektrisch löschbarer, programmierbarer Nur-Lesespeicher.

Eine Erfassungsrate der Nutzungsdaten der Batterieeinheit weist bevorzugt einen definierten Wert zwischen 6/s und 6/h auf, bevorzugt zwischen 1/s und 1/min, besonders bevorzugt 6/min oder 1/min. Nach den definierten Zeitintervallen werden beispielsweise die aktuelle Temperatur und die aktuelle Spannung der Zellen in dem Histogramm vermerkt. Für Messwerte wie Temperatur und SOC können weitere bevorzugte Abtastraten zwischen 1/min und 6/h, insbesondere bei ca. 1/min liegen. Für Spannungen wird bevorzugt ein gefilterter Wert gespeichert, beispielsweise ein Mittelwert über einen definierten Zeitraum, wobei bevorzugte Zeiträume ebenfalls bei ca. 1 min liegen. Die Erfassungsrate der jeweiligen Nutzungsdaten der Batterieeinheit liegt bevorzugt in einem Bereich, welcher eine On-Board-Diagnose (OBD) unterstützt.

Die Nutzungsdaten der Batterie umfassen beispielsweise die Temperatur, den Ladezustand, den abgegebenen Strom oder die bereitgestellte Spannung. Ebenso können Nutzungsdaten hieraus abgeleitete Größen umfassen, beispielsweise zeitlich aufsummierte oder integrierte Größen, miteinander multiplizierte oder anderweitig aggregierte Größen, wie beispielsweise auch der so genannte Gesundheitszustand (SOH) der Batterie in geeigneten quantifizierbaren Einheiten. Außerdem können Differenzwerte zwischen minimalen und maximalen Zuständen, beispielsweise von Ladungszuständen, relative Batterieleistungen oder Anzahl von Durchführungen von Lade- und Entladezyklen in den Nutzungsdaten umfasst sein.

Mit abgeleiteten Werten können beispielsweise relative Häufigkeiten, systematische Verschiebungen oder Wichtungen der Erfassungen der Nutzungsdaten bezeichnet sein, die geeignet sind, die Aussage- oder Vergleichskraft der erfassten Nutzungsdaten zu vergrößern.

Mit der Quantisierung der erfassten Nutzungsdaten wird bezeichnet, dass Stützstellen definiert werden, die jeweils Grenzen von Intervallen darstellen, und die erfassten Nutzungsdaten den Intervallen zugeordnet werden. Die Intervalle können dabei unterschiedlich groß oder regelmäßig definiert sein. Beispielsweise kann ein Temperaturbereich zwischen -40 °C und +80 °C definiert und in Intervallen von 10 °C, 5 °C, 2 °C oder 1 °C unterteilt sein. Bei der Größe und Anzahl der Intervalle wird zum einen der vom Histogramm eingenommene Speicher berücksichtigt und zum anderen die Aussagekraft der derart quantisierten erfassten Nutzungsdaten.

Vorteilhafte Weiterbildungen und Verbesserungen der in den unabhängigen Ansprüchen angegebenen Verfahren sind durch die in den abhängigen Ansprüchen aufgeführten Maßnahmen möglich.

Erfindungsgemäss ist der zusätzliche Informationsträger eine Prüfsumme, die anhand des Histogramms und eines individuellen Schlüssels des zentralen Steuergeräts ermittelt wird. Für den Fall, dass die Batterie mehrere Batteriemodule mit zugeordneten Modulsteuergeräten aufweist, wird das Histogramm und weitere zusätzliche Informationsträger gemäß bevorzugten Ausführungsformen zusätzlich in nicht-flüchtige Speicher zumindest eines Modulsteuergeräts gespeichert. Die weiteren zusätzlichen Informationsträger sind dabei ebenfalls zur Durchführung von Validitätsprüfungen des Histogramms eingerichtet.

Für den Fall, dass die Batterie mehrere Batteriemodule mit zugeordneten Modulsteuergeräten aufweist, ist nach einer Ausführungsform der zusätzliche Informationsträger eine Prüfsumme, die anhand des Histogramms und eines individuellen Schlüssels zumindest eines Modulsteuergeräts ermittelt wird. Das zentrale Steuergerät ermittelt bevorzugt zu jedem vorhandenen Modulsteuergerät zumindest einen zusätzlichen Informationsträger, übermittelt das Histogramm mit dem zusätzlichen Informationsträger an das jeweilige Modulsteuergerät. Das jeweilige Modulsteuergerät validiert das Histogramm anhand des zusätzlichen Informationsträgers und speichert das validierte Histogramm in seinem nicht-flüchtigen Speicher ab.

Dabei kann vorgesehen sein, dass das Modulsteuergerät werksseitig mit einem individuellen Schlüssel versehen wird, welcher in einem nicht-flüchtigen Speicher des Modulsteuergeräts abgelegt wird. Beim Fertigen der Batterie wird der individuelle Schlüssel von dem zentralen Steuergerät aus den einzelnen Modulsteuergeräten ausgelesen und in dem zentralen Steuergerät gespeichert. Auf Seiten des zentralen Steuergeräts und des Modulsteuergeräts kann vorgesehen sein, dass der Schlüssel hiernach verschlüsselt im Speicher abgelegt wird, so dass er für einen Angreifer nicht auslesbar ist.

Nach einer alternativen Ausführungsform erhalten die Modulsteuergeräte ihre individuellen Schlüssel bei einem Initialisierungsvorgang, welcher beispielsweise einem ersten Start der Batterie zugeordnet ist. Hierbei kann vorgesehen sein, dass die einzelnen Modulsteuergeräte bei der Initialisierung an das zentrale Steuergerät das Fehlen eines individuellen Schlüssels melden, und dass der Schlüssel daraufhin von dem zentralen Steuergerät erzeugt wird und an das jeweilige Modulsteuergerät kommuniziert wird, wo es abgespeichert wird.

Für den Fall, dass ein Modul ausgetauscht wird, ist bevorzugt vorgesehen, dass das neu hinzugefügte Modulsteuergerät beispielsweise werksseitig mit einer individuellen Steuergeräteidentifikation versehen wird. Auch das zentrale Steuergerät speichert die individuelle Steuergeräteidentifikation des neuen Batteriemoduls, damit in den folgenden Fahrzyklen die Nutzungshistogramme mit der zu dem neuen Batteriemodul passenden Authentifizierungsinformation versehen werden können. Für den Fall, dass das Batteriemodul in einer Werkstatt oder beim Hersteller ausgetauscht wird, kann beispielsweise dafür gesorgt werden, dass nach dem Austausch des Moduls eine Initialisierungssequenz durchlaufen wird, welche dem neuen Modulspeichergerät eine neue Modulsteuergerätidentifikation zuweist und die Identifikation auch in dem zentralen Steuergerät gespeichert wird. Somit wird sichergestellt, dass das zentrale Steuergerät die korrekte Authentifizierungsinformation für das neue Modul berechnet und das neue Modul die Nutzungshistogramme korrekt zu authentifizieren vermag.

Für den Fall, dass die Batterie mehrere Module mit zugeordneten Modulsteuergeräten umfasst, kann zur Umsetzung des Schrittes vi) vorgesehen sein, dass das Modulsteuergerät ein bestehendes Histogramm aus seinem nicht-flüchtigen Speicher lädt, das vom zentralen Steuergerät empfangene und validierte Histogramm und das bestehende Histogramm zu einem aktualisierten Histogramm geeignet zusammengefügt und in den nicht-flüchtigen Speicher des Modulsteuergeräts speichert. Zusätzlich hierzu kann wiederum dezentral in jedem Modulsteuergerät wie hierin beschrieben zumindest ein weiterer zusätzlicher Informationsträger ermittelt werden, der zu einer Validitätsprüfung des lokal zu speichernden aktualisierten Histogramms eingerichtet ist. Das aktualisierte Histogramm und ggf. der zusätzliche Informationsträger werden daraufhin in den nicht-flüchtigen Speicher des Modulsteuergeräts gespeichert. Beim Auslesen kann somit überprüft werden, ob eine Veränderung des lokal zu speichernden Histogramms stattgefunden hat.

Bevorzugt ist vorgesehen, dass beim Misslingen einer Validierung eine Fehlermeldung vom jeweiligen Modulsteuergerät an das zentrale Steuergerät übermittelt wird. Es kann vorgesehen sein, dass das zentrale Steuergerät daraufhin weitere Maßnahmen einleitet, wie beispielsweise die Sperrung des Batteriemanagementsystems oder ein Speichern einer Fehlermeldung, d. h. einer Meldung über die Fälschung der Nutzungsdaten für das betroffene Batteriemodul. Auch das Modulsteuergerät kann das Nutzungshistogramm mit dem Vermerk der Fälschung speichern. Es kann auch vorgesehen sein, dass bei einem Misslingen einer Validierung das Modulsteuergerät das gefälschte Nutzungshistogramm auf Grund der Fälschung verwirft und einen Zähler inkrementiert. Dieser Zähler kann im nächsten Fahrzyklus an das zentrale Steuergerät übermittelt werden. Hieraufhin kann vorgesehen sein, dass das zentrale Steuergerät entscheidet, dass eine maximale Anzahl an Fälschungen erreicht wurde und kann die Benutzung der Batterie sperren oder reduzieren, beispielsweise einen sog. *limp home* initiieren.

Erfindungsgemäss wird für das Histogramm als zusätzlicher Informationsträger eine Prüfsumme gebildet. Derartige Prüfsummen eignen sich zur Bestimmung, ob das Histogramm korrupt ist oder ob es zur Analyse von Nutzungsinformationen verwendet werden kann. Die Prüfsumme wird beispielsweise mittels einer zyklischen Redundanzprüfung oder einer Anwendung einer Hashfunktion gebildet. Bei der zyklischen Redundanzprüfung (CRC, cyclic redundancy check) wird eine Bitfolge des Histogramms durch ein festgelegtes Generatorpolynom, das sogenannte CRC-Polynom Modulo 2 geteilt, wobei ein Rest bleibt. Dieser Rest ist der CRC-Wert, der dem Histogramm angefügt wird. Zusätzlich hierzu oder alternativ hierzu kann eine Hashfunktion, wie z. B. SHA-1, SHA-1 oder SHA-3 vorgesehen sein, welche bekanntermaßen die Eingabemenge, hier den betreffenden Teil des Histogramms, auf eine kleine Zielmenge, die Hashwerte abbildet. Hashfunktionen sind geeignet, die Integrität der Daten zu bestätigen. Das heißt, es ist praktisch unmöglich, durch beabsichtigte Modifikation ein Histogramm zu erzeugen, das den gleichen Hash-Wert wie ein gegebenes Histogramm hat. Der Hash-Wert kann dem Histogramm ebenfalls angefügt werden.

Die vorgestellten Verfahren können insbesondere an Lithium-Ionenbatterien und an Nickel-Metallhydridbatterien Anwendung finden. Vorzugsweise finden sie Anwendung an mehreren und insbesondere an allen Zellen einer oder mehrerer Batterien, die im Wesentlichen gleichzeitig betrieben werden.

Erfindungsgemäß wird außerdem eine Datenstruktur vorgeschlagen mit zumindest einem Histogramm, das Häufigkeitswerte des Auftretens bestimmter Werte von quantisierten Nutzungsdaten oder daraus abgeleitete Werte aufweist, und mit zumindest einem zusätzlichen Informationsträger, der zu einer Validitätsprüfung des Histogramms eingerichtet ist. Die Datenstruktur wurde bei der Durchführung des erfindugsgemässen Verfahrens erstellt. Die Datenstruktur wird beispielsweise von einer Computereinrichtung zu Wartungs- und Servicezwecken, zum Aktualisieren der gespeicherten Informationen, zur Identifikation von fehlerhaften Informationen oder zur Validierung der Informationen ausgelesen.

Erfindungsgemäß wird weiterhin ein Computerprogramm vorgeschlagen, gemäß dem das erfindungsgemässe Verfahren durchgeführt wird, wenn das Computerprogramm auf einer programmierbaren Computereinrichtung ausgeführt wird. Bei dem Computerprogramm kann es sich beispielsweise um ein Modul zur Implementierung einer Einrichtung zur Bereitstellung oder zur Auslesung von Informationen zu Wartungs- und Servicezwecken einer Batterieeinheit und/oder ein um ein Modul zur Implementierung eines Batteriemanagementsystems eines Fahrzeugs handeln. Das Computerprogramm kann auf einem maschinenlesbaren Speichermedium gespeichert werden, etwa auf einem permanenten oder wiederbeschreibbaren Speichermedium oder in Zuordnung zu einer Computereinrichtung, beispielsweise auf einem tragbaren Speicher, wie einer CD-ROM, DVD, einem USB-Stick oder einer Speicherkarte. Zusätzlich oder alternativ dazu kann das Computerprogramm auf einer Computereinrichtung, wie etwa auf einem Server oder einem Cloud-Server, zum Herunterladen bereitgestellt werden, beispielweise über ein Datennetzwerk, wie das Internet, oder eine Kommunikationsverbindung, wie etwa eine Telefonleitung oder eine drahtlose Verbindung.

Erfindungsgemäß wird außerdem ein Batteriemanagementsystem (BMS) bereitgestellt, mit einer Einheit zur Erfassung und Quantisierung von Nutzungsdaten einer Batterieeinheit, einer Einheit zum Erstellen oder Aktualisieren eines Histogramms, das Häufigkeitswerte des Auftretens bestimmter Werte der einzelnen quantisierten Nutzungsdaten oder daraus abgeleitete Werte aufweist, einer Einheit zur Ermittlung eines zusätzlichen Informationsträgers in Form einer mittels einer Einwegfunktion berechneten Prüfsumme, der zu einer Validitätsprüfung des Histogramms eingerichtet ist, und einer Einheit zum Speichern des Histogramms und des zumindest einen zusätzlichen Informationsträgers in einen nicht-flüchtigen Speicher.

Die Einheit zum Speichern des Histogramms und des zusätzlichen Informationsträgers in einen nicht-flüchtigen Speicher kann sowohl auf Seiten eines zentralen Steuergeräts (BCU) als auch auf Seiten eines Modulsteuergeräts (CPU) angeordnet sein. Ebenso können mehrere Einheiten zum Speichern der Histogramme und der zusätzlichen Informationsträger vorhanden sein, wobei eine erste Einheit der BCU zugeordnet sein kann und weitere Einheiten den einzelnen CPUs.

Das Batteriemanagementsystem umfasst bevorzugt weitere Einheiten zum Validieren von Histogrammen anhand der zusätzlichen Informationsträger. Derartige Einheiten können sowohl auf der Seite der BCU als auch auf der Seite der CPU angeordnet sein. Das Batteriemanagementsystem umfasst bevorzugt außerdem Kommunikationseinheiten zum Übermitteln von Daten zwischen der BCU und der CPU.

Erfindungsgemäß wird außerdem eine Batterie, insbesondere eine Lithium-Ionenbatterie oder ein Nickel-Metallhydridbatterie, zur Verfügung gestellt, die ein Batteriemanagementsystem umfasst und mit einem Antriebssystem eines Kraftfahrzeugs verbindbar ist, wobei das Batteriemanagementsystem wie zuvor beschrieben ausgebildet ist und/oder eingerichtet ist, das erfindungsgemäße Verfahren auszuführen.

Die Begriffe "Batterie" und "Batterieeinheit" werden in der vorliegenden Beschreibung dem üblichen Sprachgebrauch angepasst für Akkumulator bzw. Akkumulatoreinheit verwendet. Die Batterie umfasst bevorzugt eine oder mehrere Batterieeinheiten, die eine Batteriezelle, ein Batteriemodul, ein Modulstrang oder ein Batteriepack umfassen können. Die Batteriezellen sind dabei vorzugsweise räumlich zusammengefasst und schaltungstechnisch miteinander verbunden, beispielsweise seriell oder parallel zu Modulen verschaltet. Mehrere Module können sogenannte Batteriedirektkonverter (BDI, *Battery Direct Converter*) bilden und mehrere Batteriedirektkonverter einen Batteriedirektinverter (BDI, *Battery Direct Inverter*).

Erfindungsgemäß wird außerdem ein Kraftfahrzeug mit einer derartigen Batterie zur Verfügung gestellt, wobei die Batterie mit einem Antriebssystem des Kraftfahrzeugs verbunden ist. Bevorzugt wird das Verfahren bei elektrisch angetriebenen Fahrzeugen angewendet, bei welchen eine Zusammenschaltung einer Vielzahl von Batteriezellen zur Bereitstellung der nötigen Antriebsspannung erfolgt.

### Vorteile der Erfindung

Mit dem erfindungsgemäßen Verfahren kann eine Manipulation von Histogrammen im Speicher der Steuergeräte verhindert werden, sowohl bei zentralen Steuergeräten als auch bei einzelnen Modulsteuergeräten. Hierdurch kann die unerlaubte Nutzung von Batteriepacks außerhalb von Spezifikationen durch Manipulation der Nutzungshistogramme aufgedeckt werden. Wenn ein Histogramm im Speicher des betreffenden Speichergeräts abgespeichert wurde, und nicht den korrekten Informationsträger aufweist, so ist dies ein Hinweis auf die Manipulation des Nutzungshistogramms oder auf einen defekten Speicher. Der Informationsträger ist ohne exakte Kenntnis der Berechnungsvorschrift und eine eindeutige Identifikation des Steuergeräts nicht fälschbar. Eine plausible Signatur kann von einem Angreifer nicht berechnet werden. Auch das sog. *Reverse Engineering* der Signaturberechnung mittels ausreichend vieler bekannter Histogramm-Signatur-Kombinationen kann beispielsweise durch Verwendung einer individuellen Steuergeräteseriennummer stark erschwert werden.

Das zentrale Batteriesteuergerät und die lokalen Modulsteuergeräte können beliebig konfiguriert werden und auf die Fälschung reagieren, beispielsweise durch Vermerke im Fehlerspeicher oder Sperren der Batterie. Dem Steuergerät wird außerdem die Möglichkeit zur Erkennung von Speicherdefekten gegeben, und es kann entsprechend reagieren und die defekten Speicherzellen nicht mehr weiter verwenden.

Besonders vorteilhaft ist außerdem die dezentrale Speicherung der Informationen auf Modulsteuergeräten. Die Nutzungshistogramme von ausgebauten Modulen können ausgelesen und analysiert werden. Hierzu ist das zentrale Modulsteuergerät im Prinzip nicht nötig. Der Austausch von Modulen hat außerdem keinen Einfluss auf die Histogramme der übrigen Module. Das neu eingebaute Modul wird mit einem leeren Histogramm initialisiert.

Weiterhin besonders vorteilhaft ist die Verwendung von individuellen Schlüsseln für die einzelnen Modulsteuergeräte. Für den unwahrscheinlichen Fall, dass ein Angreifer die Absicherung der Nutzungsinformation für ein Modul entschlüsselt hat, kann dieser maximal die Nutzungsinformationen dieses einen Moduls verfälschen, alle weiteren Module bleiben nach wie vor abgesichert.

Ein weiterer Vorteil ergibt sich durch die Skalierbarkeit des Systems. Die Anzahl der erfassten Messgrößen, d.h. der Dimensionen des Histogramms, kann beliebig erweitert werden. So können auch hochdimensionale Histogramme verwendet werden, welche beispielsweise darüber Informationen bereitstellen, wie lange eine Batterie bei einer bestimmten Kombination von einem definierten Ladungsstand, einer definierten Temperatur und einem definierten Stromfluss verwendet wurde. Das Verfahren kann außerdem parallel auf verschiedenen unabhängigen Histogrammen angewendet werden.

### Kurze Beschreibung der Zeichnungen

Ausführungsbeispiele der Erfindung sind in den Zeichnungen dargestellt und in der nachfolgenden Beschreibung näher erläutert. Es zeigen
- Figur 1: ein Beispiel für eine Aktualisierung eines zweidimensionalen Histogramms,
- Figur 2: ein Beispiel für eine manipulationsgeschützte Speicherung von Histogrammen in einem Batteriemanagementsystem,
- Figur 3: ein Batteriemanagementsystem nach einer Ausführungsform der Erfindung,
- Figur 4: ein Beispiel für eine dezentrale Speicherung von Histogrammen in einem Batteriemanagementsystem,
- Figur 5: ein Beispiel für ein Angriffsszenario bei dezentral gespeicherten Histogrammen,
- Figur 6: ein Beispiel für eine manipulationsgeschützte dezentrale Speicherung von Histogrammen in einem Batteriemanagementsystem.

### Ausführungsformen der Erfindung

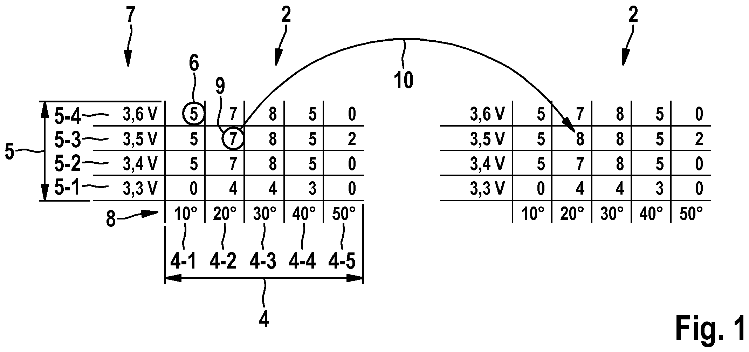

Figur 1 zeigt ein zweidimensionales Histogramm 2 vor und nach einem Aktualisierungsschritt, der hier beispielhaft als ein Pfeil 10 dargestellt ist. Bei der Erstellung des Histogramms 2 werden mit einer definierten Erfassungsrate die Temperatur und die Spannung ermittelt und der entsprechende Histogrammwert oder Häufigkeitswert 6 um Eins erhöht. Im Beispiel wird ein Update-Schritt 10 mit einer Erhöhung der Häufigkeit der Messung 9 "20°/3,5 Volt" dargestellt. Aus dem Histogramm 2 ist beispielsweise ersichtlich, dass die Batterie bei 20 °C und 3,5 V Spannung nach dem Update-Schritt 10 bei 8 Messungen betrieben wurde, oder auch, dass die Batterie kein Mal bei 0 °C betrieben wurde. Das Histogramm 2 wird im Rahmen der Erfindung auch als ein Nutzungshistogramm bezeichnet.

Im dargestellten Beispiel wird ein Gesamtintervall 4 von Temperaturen von -10 °C bis +50 °C in 5 Einzelintervallen 4-1, 4-2,....4-5 eingeteilt, wobei die einzelnen Intervalle 4-1, 4-2,....4-5 hier beispielhaft eine Intervallbreite von 10 °C aufweisen. Die angegebenen Temperaturwerte 8 können sich beispielsweise auf die Mittelwerte der durch die Intervallgrenzen gegebenen Werte beziehen, oder auch auf den Wert der linken oder der rechten Grenze.

Im dargestellten Beispiel wird außerdem ein Gesamtintervall 5, welches hier beispielhaft Spannungswerte 7 von 3,3 V bis 3,6 V umfasst, in 4 Einzelintervallen 5-1, 5-2, ... 5-4 eingeteilt, wobei die einzelnen Intervalle 5-1, 5-2, ... 5-4 hier beispielhaft eine Intervallbreite von 0,1 V aufweisen. Die angegebenen Spannungswerte 7 können sich ebenfalls auf die Mittelwerte der durch die Intervallgrenzen gegebenen Werte beziehen, oder auch auf den Wert der linken oder der rechten Grenze.

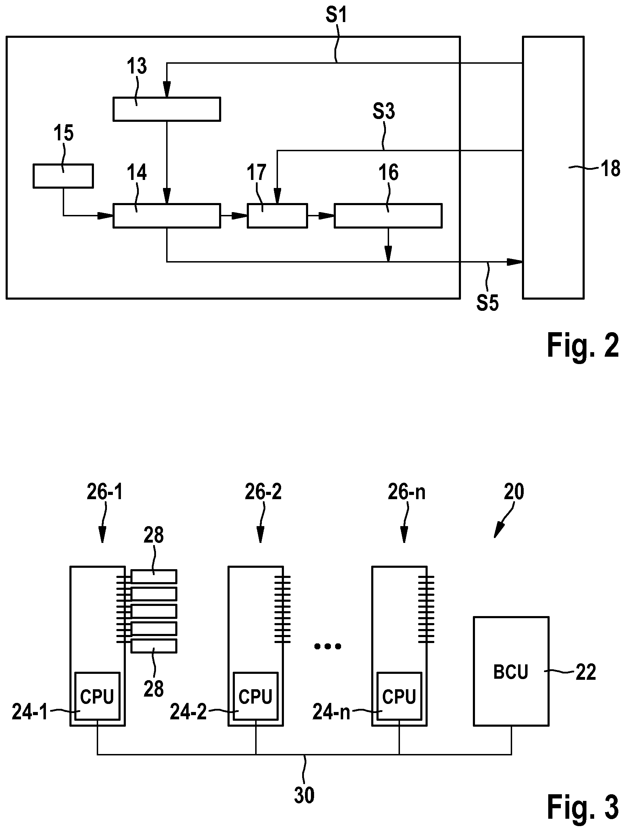

Figur 2 zeigt ein Beispiel für eine manipulationsgeschützte Speicherung von Histogrammen in einem Steuergerät, wie etwa in einem zentralen Steuergerät eines Batteriemanagementsystems oder dezentral in einem Modulsteuergerät. In einem ersten Schritt S1 lädt eine Einheit 13 ein bestehendes Histogramm aus einem nicht-flüchtigen Speicher 18 des Steuergeräts. Eine weitere Einheit 15 erfasst und quantisiert Nutzungsdaten der Batterieeinheit und bildet hieraus ein Histogramm für den aktuellen Fahrzyklus, wobei hierbei üblicherweise viele der mit Bezug zu Figur 1 beschriebenen einzelnen Update-Schritte 10 erfolgen. Die erfassten quantisierten Nutzungsdaten und das bestehende Histogramm werden einer weiteren Einheit 14 zugeführt, welche hieraus das aktualisierte Histogramm erstellt, beispielsweise indem es die beiden Histogramme komponentenweise addiert.

Die Einheit 14 zur Erstellung des Histogramms übermittelt das aktualisierte Histogramm einer Einheit 17 zur Ermittlung eines zusätzlichen Informationsträgers. Die Einheit 17 zur Ermittlung des zusätzlichen Informationsträgers ermittelt in einem Schritt S3 beispielsweise die Seriennummer des Steuergeräts aus dem nicht-flüchtigen Speicher 18 des Steuergeräts und berechnet mittels einer Einwegfunktion f(x,y) aus der Seriennummer und dem aktualisierten Histogramm, beispielsweise mittels einer XOR-Funktion über alle Einträge des Histogramms, einen zusätzlichen Informationsträger 16, der zu einer Validitätsprüfung des Histogramms eingerichtet ist. In einem weiteren Schritt S5 werden das aktualisierte Histogramm und der zusätzliche Informationsträger 16 im nicht-flüchtigen Speicher 18 des betreffenden Steuergeräts gespeichert.

Die Einwegfunktion f(x,y) → z ist bevorzugt mit solchen Eigenschaften definiert, dass ihr Funktionswert z einfach zu berechnen ist und eine Umkehrung der Funktion sehr aufwändig ist. Beispiele für derartige Einwegfunktionen finden sich in der Kryptographie, beispielsweise Hash-Funktionen, insbesondere SHA-1, SHA-2 oder SHA-3, oder als Multiplikation von Primzahlen. Die Einwegfunktion wird im Batteriemanagementsystem implementiert. Bei der Einwegfunktion f(x,y) → z ist der Wert y eine eindeutige Steuergeräteidentifikation, beispielsweise eine Seriennummer des Steuergeräts. Durch den Wert y wird sichergestellt, dass die gleiche Einwegfunktion in unterschiedlichen Steuergeräten unterschiedliche Ergebnisse liefern. Der Eingabewert x ist das Histogramm. Beispielsweise können alle Histogrammeinträge per XOR zu einem Wert verknüpft werden, welcher dann zusammen mit dem Wert y in die Signaturberechnung eingeht. Daraufhin wird das Histogramm mit der Authentifizierungsinformation, einer sog. Signatur versehen, welche im Rahmen der Erfindung als zusätzlicher Informationsträger 16 bezeichnet sein kann. Diese Signatur, beispielsweise ein 32-bit-Wert, wird aus dem Histogramm und dem eindeutigen Datenelement des Steuergeräts berechnet und zusammen mit dem Histogramm abgespeichert. Ohne Kenntnis der Berechnungsvorschrift der Signatur kann ein Angreifer keine plausible Kombination von Nutzungshistogramm und passender Signatur erzeugen und im Steuergerät speichern. Das Zurückschließen auf die Berechnungsvorschrift durch Auslesen von Histogrammen und Signaturen nach jedem Fahrzyklus wird durch die Verwendung des steuergeräteindividuellen Schlüssels stark erschwert.

Im Schadens-/Gewährleistungsfall werden das Histogramm, die Signatur und die Seriennummer aus dem nicht-flüchtigen Speicher 18 des Steuergeräts ausgelesen. Aus dem Histogramm und der Seriennummer wird erneut eine Signatur berechnet. Stimmt diese Signatur mit der gespeicherten Signatur aus dem Steuergerät überein, so liegt keine Manipulation des Nutzungshistogramms im Steuergerät vor. Stimmen die Signaturen nicht überein, wurde das Histogramm im Steuergerät manipuliert.

Figur 3 zeigt ein Batteriemanagementsystem 20 gemäß einer Ausführungsform der vorliegenden Erfindung. Das Batteriemanagementsystem umfasst ein zentrales Steuergerät 22, welches auch als BCU (*Battery Control Unit*), bezeichnet werden kann und eine Anzahl von Batteriemodulen 26-1, 26-2, ... 26-n, welche jeweils eigene Modulsteuergeräte 24-1, 24-2, ...24-n aufweisen, welche auch als CMC (*Cell Module Controller*) bezeichnet werden. Jedem Modul 26-1, 26-2, ... 26-n sind mehrere Batteriezellen 28 zugeordnet, wobei diese üblicherweise in Serie und teilweise zusätzlich parallel geschaltet werden, um die geforderten Leistungs- und Energiedaten mit dem Batteriesystem zu erzielen. Die einzelnen Batteriezellen 28 sind beispielsweise Lithium-Ionenbatterien mit einem Spannungsbereich von 2,8 bis 4,2 V. Die Kommunikation zwischen dem zentralen Steuergerät 22 und den Modulsteuergeräten 26-1, 26-2, ... 26-n erfolgt über einen Kommunikationskanal 30, beispielsweise über einen CAN-Bus.

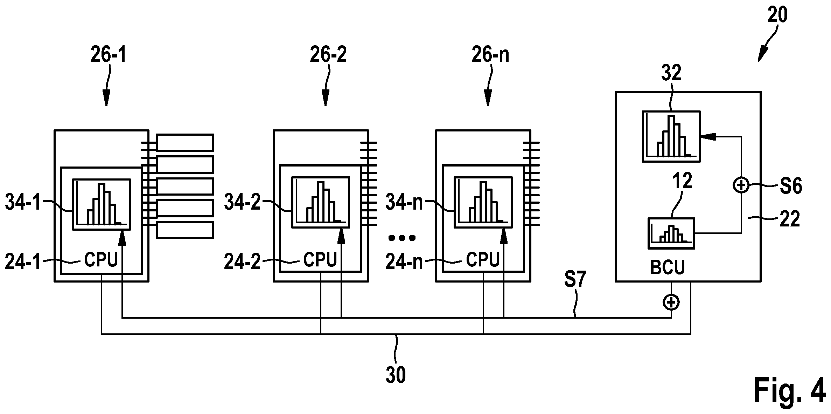

Figur 4 zeigt eine dezentrale Speicherung von Histogrammen in einem Batteriemanagementsystem 20. Das Batteriemanagementsystem 20 kann wie mit Bezug zu Figur 3 beschrieben aufgebaut sein und umfasst ein zentrales Steuergerät 22 und Modulsteuergeräte 24. Ein geeignetes Erfassungs- und Quantisierungsmodul, welches wie mit Bezug zu Figur 2 beschrieben ausgebildet sein kann (nicht dargestellt), erstellt ein aktuelles Histogramm 12 über die Nutzung der Batterie während des letzten Fahrzyklus. In einem Schritt S6 wird das aktuelle Histogramm 12 zu einem Gesamthistogramm 32 hinzugefügt, welches in einem nicht-flüchtigen Speicher des zentralen Steuergeräts 22 abgelegt ist. Hierbei kann ein zusätzlicher Informationsträger ermittelt werden, welcher eine Validierung des Gesamthistogramms 32 im nicht-flüchtigen Speicher des zentralen Steuergeräts 22 ermöglicht, wie mit Bezug zu Figur 2 beschrieben. Im Rahmen von Gewährleistungsansprüchen kann das Gesamthistogramm 32 aus dem nicht-flüchtigen Speicher des zentralen Steuergeräts 22 ausgelesen werden und zur Auswertung der Nutzung der Batterie herangezogen werden.

Zusätzlich wird den Modulsteuergeräten 24 in einem weiteren Schritt S7 das Nutzungshistogramm 12 des aktuellen Fahrzyklus übermittelt. In den Modulsteuergeräten 24 wird das aktuelle Histogramm 12 den dort lokal und dezentral gespeicherten Nutzungshistogrammen 34 hinzugefügt, wobei dies wie mit Bezug zu Figur 2 beschrieben erfolgen kann. Insbesondere kann vorgesehen sein, dass den in den Modulsteuergeräten 24 gespeicherten Histogrammen 34 weitere zusätzliche Informationsträger angefügt werden, die wiederum zu einer Validitätsprüfung der Histogramme 34 eingerichtet sind. Die Übermittlung des aktuellen Histogramms 12 zu den einzelnen Modulsteuergeräten 24 kann über den Kommunikationskanal 30 erfolgen.

Im Gewährleistungsfall kann sowohl das Gesamthistogramm 32 des zentralen Steuergeräts 22 als auch die Histogramme 34 der einzelnen Module 26 ausgelesen werden. Auch in einem Fall, dass einzelne Module 26 ausgetauscht werden, gibt das Nutzungshistogramm 32 in dem zentralen Steuergerät 22 eine Auskunft über die Nutzung des gesamten Batteriepacks. Im Falle des Austauschs von Modulen 26 geben die Nutzungshistogramme 34 in den Modulen 26 Auskunft über die detaillierte Nutzung des jeweiligen Moduls 26. Ausgebaute Module können herstellerseitig einzeln analysiert werden, ohne dass ein Zugriff auf das zentrale Steuergeräts 22 erfolgen muss. Bevorzugt kann vorgesehen sein, dass neu eingebaute Module 26 nur Nutzungsdaten ab dem Zeitpunkt des Einbaus erfassen.

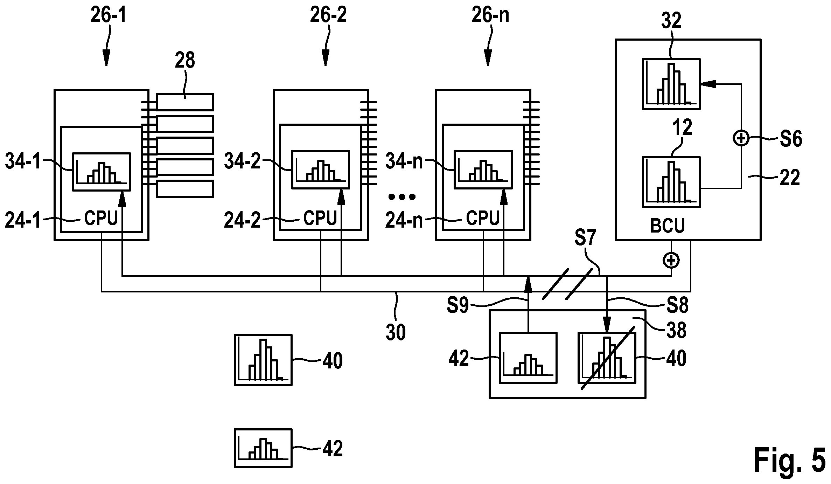

Figur 5 zeigt ein Beispiel für ein Abfangen von übermittelten Daten und Ersetzen der Daten durch manipulierte Daten durch einen Angreifer 38. Das System kann wie mit Bezug zu Figur 4 beschrieben aufgebaut sein, insbesondere speichert das zentrale Steuergerät 22 nach jedem Fahrzyklus in einem Schritt S6 das aktuelle Histogramm 12 in dem Gesamthistogramm 32 und übermittelt es in einem Schritt S7 den dezentralen Modulsteuergeräten 24, welche das aktuelle Histogramm 12 den im Modulsteuergerät 24 gespeicherten Histogrammen 34 hinzufügen.

Im dargestellten Beispiel fängt der Angreifer 38 die in Schritt 7 übermittelten Daten 40 in einem Schritt S8 ab und ersetzt sie in einem weiteren Schritt S9 durch manipulierte Daten 42. Der Angreifer 38 trennt dabei die Verbindung über den Kommunikationskanal 30 zwischen dem zentralen Steuergerät 22 und den Modulsteuergeräten 24 auf. Es kann vorgesehen sein, dass jegliche Kommunikation außer den Nutzungsinformationen unverändert weitergeleitet wird. Sobald aber nach einem Fahrzyklus das aktuelle Histogramm 12 von dem zentralen Steuergerät 22 an die Modulsteuergeräte 24 gesendet wird, wird dieses abgefangen und durch manipulierte Nutzungsinformationen 42 ersetzt. In Figur 5 ist dargestellt, wie ein Histogramm 40 mit hoher Nutzung abgefangen und durch ein Histogramm 42 mit geringerer Nutzung ersetzt wird. Dabei können beispielsweise Bereiche ausgeblendet werden, in welchen die Batterie nicht zu nutzen war oder es kann insgesamt eine verringerte Nutzung übermittelt werden, so dass eine falsche Lebensdauer bzw. ein falsches Alter der Batterie und des Batteriemoduls errechnet wird. Im Falle von Gewährleistungsansprüchen ist es schwierig bis unmöglich, Rückschlüsse auf die tatsächliche Nutzung der Batterie zu treffen. Zwar gibt das Nutzungshistogramm 32 des zentralen Steuergeräts 22 Auskunft über die Nutzung der gesamten Batterie, da aber Module 26 mit Modulsteuergeräten 24 ausgetauscht worden sein können, kann nicht nachvollzogen werden, wie stark die vorhandenen Module 26 tatsächlich genutzt worden sind.

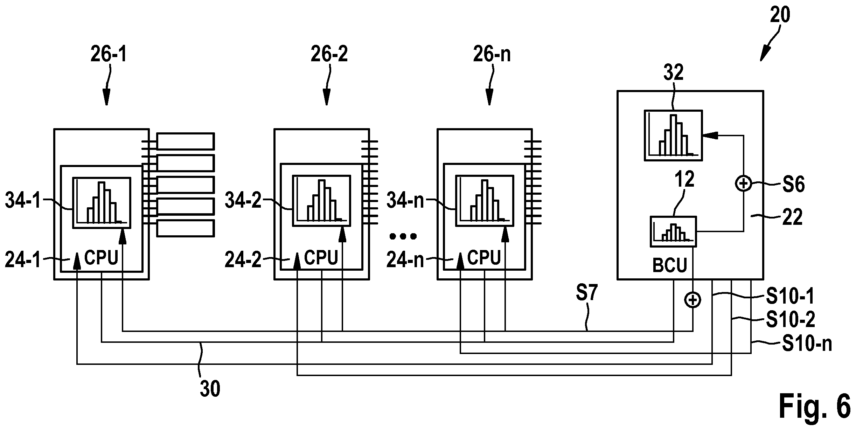

Figur 6 zeigt ein Beispiel für einen erfindungsgemäßen Manipulationsschutz bei dezentraler Speicherung von Histogrammen im Batteriemanagementsystem 20. Das System kann wie mit Bezug zu Figuren 3-5 beschrieben aufgebaut sein. Während eines Fahrzyklus wird ein Nutzungshistogramm 12 für den Fahrzyklus von dem zentralen Steuergerät 22 erstellt, einem Gesamthistogramm 32 hinzugefügt und in einem Schritt S6 in einem nicht-flüchtigen Speicher des zentralen Steuergeräts 22 abgelegt. Zusätzlich wird in einem Schritt S7 das erstellte Histogramm 12 beispielsweise über den Kommunikationsbus 30 von dem zentralen Steuergerät 22 an die Modulsteuergeräte 24 kommuniziert. Zusätzlich wird in einem Schritt S10 jeweils der zusätzliche Informationsträger vom zentralen Steuergerät 22 an die Modulsteuergeräte 24 übermittelt. Da der zusätzliche Informationsträger bevorzugt für jedes Modul 26 verschieden ist, zergliedert sich dieser Schritt in einzelne Schritte S10-1, S10-2, ... S10-n. Insbesondere kann nach einer bevorzugten Ausführungsform vorgesehen sein, dass für jedes Modulsteuergerät 24 von dem zentralen Steuergerät 22 ein individueller der zusätzliche Informationsträger aus dem aktuellen Nutzungshistogramm 12 und dem individuellen Schlüssel des Modulsteuergeräts 24 errechnet wird, wobei der individuelle Schlüssel des Modulsteuergeräts 24 im zentralen Steuergerät 22 gespeichert ist. Dabei wird eine Prüfsumme mittels des individuellen Schlüssels des Modulsteuergeräts 24 und der einzelnen Werte des Histogramms 12 errechnet wird. Insbesondere kann die Verwendung einer Einwegfunktion vorgesehen sein, wie mit Bezug zu Figur 2 beschrieben mit Eingabeparametern des Histogramms 12 und des individuellen Schlüssels. Alternativ oder zusätzlich kann vorgesehen sein, dass eine asymmetrische Verschlüsselung, beispielsweise mittels Public Key Encryption erfolgt, wobei die Schlüssel zur Authentifizierung aus den individuellen Modulsteuergeräteschlüsseln abgeleitet werden.

In den einzelnen Modulsteuergeräten 24-1, 24-2, ... 24-n wird das übermittelte Nutzungshistogramm 12 anhand des zusätzlichen Informationsträgers, d. h. anhand der individuellen Authentifizierungsinformation verifiziert. Jedes Modulsteuergerät 24 prüft dabei den zusätzlichen Informationsträger mittels seines individuellen Schlüssels und des Nutzungshistogramms 12. Folgende Möglichkeiten bestehen:
a) Die von dem zentralen Steuergerät 22 kommunizierte Authentifizierungsinformation stimmt mit der selbst berechneten Authentifizierungsinformation überein: Die Daten von dem zentralen Steuergerät 22 sind unverfälscht. Das Nutzungshistogramm 12 des letzten Fahrzyklus wird auf das bereits gespeicherte Nutzungshistogramm 34 hinzuaddiert. Das jeweils im Modulsteuergerät 24 gespeicherte Histogramm 34 wird hierzu aus dem nicht-flüchtigen Speicher des Modulsteuergeräts 24 ausgelesen, das Histogramm 12 des gerade abgelaufenen Fahrzyklus hinzuaddiert und das Ergebnis wieder im nicht-flüchtigen Speicher des Modulsteuergeräts 24 abgelegt.
b) Die von dem zentralen Steuergerät 22 kommunizierte Authentifizierungsinformation stimmt nicht mit der durch das Modulsteuergerät 24 berechneten Authentifizierungsinformation überein: die Daten wurden zwischen dem zentralen Steuergerät 22 und dem Modulsteuergerät 24 verfälscht (z.B. durch einen Angreifer). Vorgeschlagene Maßnahmen können umfassen:
   i) Verwerfen des Nutzungshistogramms und Meldung an das zentrale Steuergerät 22 über Fälschung der Daten. Das zentrale Steuergerät 22 leitet weitere Maßnahmen ein: Sperrung des Batteriemanagementsystems, Speichern der Fälschung der Nutzungsdaten für betroffenes Modul 26, etc.
   ii) Das Modulsteuergerät 24 speichert die Nutzungsdaten mit dem Vermerk der Fälschung.
   iii) Das Modulsteuergerät 24 verwirft die Nutzungsdaten aufgrund der Fälschung und inkrementiert einen Zähler. Dieser Zähler wird im nächsten Fahrzyklus an das zentrale Steuergerät 22 übermittelt. Das zentrale Steuergerät 22 kann entscheiden, dass eine Maximale Anzahl an Fälschungen erreicht wurde und kann die Benutzung der Batterie sperren/reduzieren (*"limp home"*).

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Verfahren zum Bereitstellen von Informationen zu Wartungs- und Servicezwecken einer Batterie, die ein Steuergerät (22, 24) mit einem nicht-flüchtigen Speicher (18) und mehrere Batterieeinheiten (28) aufweist, mit den folgenden Schritten:
a) Erfassen und Quantisieren von Nutzungsdaten der Batterieeinheiten (28);
b) Bilden eines Histogramms (2, 12), das Häufigkeitswerte (6) des Auftretens bestimmter Werte (7, 8) der einzelnen quantisierten Nutzungsdaten oder daraus abgeleitete Werte aufweist;
c) Ermitteln einer Prüfsumme, die anhand des Histogramms (2, 12) und eines individuellen Schlüssels des Steuergeräts (22, 24) ermittelt wird, wobei die Prüfsumme mittels einer Einwegfunktion, insbesondere einer zyklischen Redundanzprüfung oder einer Anwendung einer Hashfunktion, berechnet wird und
d) Speichern (S5) des Histogramms (2, 12) und der Prüfsumme in den nicht-flüchtigen Speicher (18) des Steuergeräts (22, 24).

2. Verfahren nach Anspruch 1, **dadurch gekennzeichnet, dass** die Batterie mehrere Module (26) mit zugeordneten Modulsteuergeräten (24) aufweist und das Histogramm (2, 12) und eine weitere Prüfsumme in einen nicht-flüchtigen Speicher (18) zumindest eines Modulsteuergeräts (24) gespeichert werden.

3. Verfahren zum Bereitstellen von Informationen zu Wartungs- und Servicezwecken einer Batterie gemäß Anspruch 1, wobei die Batterie zumindest ein Batteriemodul (26) mit einem zugeordneten Modulsteuergerät (24) und ein zentrales Steuergerät (22) umfasst, wobei zumindest ein Modulsteuergerät (24) einen nicht-flüchtigen Speicher (18) aufweist, mit den folgenden zusätzlichen Schritten, wobei in Schritt c) das Ermitteln der Prüfsumme durch das zentrale Steuergerät anhand des Histogramms (2, 12) und des individuellen Schlüssels des Modulsteuergeräts (24) erfolgt und in Schritt d) das Speichern (S5) des Histogramms (2, 12) und der Prüfsumme in den nicht-flüchtigen Speicher (18) des Modulsteuergeräts (24) erfolgt:
e) Übermitteln des Histogramms (2, 12) und der Prüfsumme von dem zentralen Steuergerät (22) an das Modulsteuergerät (24);
f) Authentifizieren des Histogramms (2, 12) anhand der Prüfsumme durch das Modulsteuergerät (24);

4. Verfahren nach Anspruch 3, **dadurch gekennzeichnet, dass** zur Umsetzung des Schrittes d) ein bestehendes Histogramm aus dem nicht-flüchtigen Speicher (18) des Modulsteuergeräts (24) geladen wird (S1), das vom zentralen Steuergerät (22) empfangene und authentifizierte Histogramm und das bestehende Histogramm zu einem aktualisierten Histogramm geeignet zusammengefügt und in den nicht-flüchtigen Speicher (18) gespeichert werden (S5).

5. Verfahren nach Anspruch 4, **dadurch gekennzeichnet, dass** bei einem Misslingen einer Authentifizierung eine Fehlermeldung oder ein Zähler vom Modulsteuergerät (24) an das zentrale Steuergerät (22) übermittelt wird.

6. Datenstruktur mit zumindest einem Histogramm (2, 12), das Häufigkeitswerte (6) des Auftretens bestimmter Werte (7, 8) von quantisierten Nutzungsdaten oder daraus abgeleitete Werte aufweist, und mit zumindest einer Prüfsumme, wobei die Datenstruktur bei der Durchführung eines der Verfahren nach einem der Ansprüche 1 bis 5 erstellt wurde.

7. Computerprogramm zur Durchführung eines der Verfahren nach einem der Ansprüche 1 bis 5, wenn das Computerprogramm auf einer programmierbaren Computereinrichtung ausgeführt wird.

8. Batteriemanagementsystem (20) mit einer Einheit (15) zur Erfassung und Quantisierung von Nutzungsdaten einer Batterieeinheit (28), einem Steuergerät, einer Einheit (14) zum Erstellen eines Histogramms (2, 12), das Häufigkeitswerte (6) des Auftretens bestimmter Werte (7, 8) der einzelnen quantisierten Nutzungsdaten oder daraus abgeleitete Werte aufweist, einer Einheit (17) zur Ermittlung einer Prüfsumme anhand des Histogramms (2, 12) und eines individuellen Schlüssels des Steuergeräts (22, 24), wobei die Prüfsumme mittels Einwegfunktion, insbesondere einer zyklischen Redundanzprüfung oder einer Anwendung einer Hashfunktion, berechnet wird, und einer Einheit zum Speichern des Histogramms (2, 12) und der Prüfsumme in einen nicht-flüchtigen Speicher (18).

9. Batterie, die mehrere Batteriezellen und ein Batteriemanagementsystem (20) nach Anspruch 8 umfasst, und die mit einem Antriebssystem eines Kraftfahrzeugs verbindbar ist.

10. Kraftfahrzeug mit einer Batterie nach Anspruch 9, wobei die Batterie mit einem Antriebssystem des Kraftfahrzeugs verbunden ist.

## Claims

1. Method for providing information for maintenance and servicing purposes for a battery comprising a control unit (22, 24) with a non-volatile memory (18) and a plurality of battery units (28), with the following steps:
a) Recording and quantizing usage data of the battery units (28);
b) Forming a histogram (2, 12) comprising the frequency values (6) of the occurrence of certain values (7, 8) of the individual quantized usage data or values derived therefrom;
c) Determining a check sum that is determined using the histogram (2, 12) and an individual key of the control unit (22, 24); wherein the check sum is calculated by means of a one-way function, in particular a cyclic redundancy check, or by using a hash function
d) Storing (S5) the histogram (2, 12) and the check sum in the non-volatile memory (18) of the control unit (22, 24)

2. Method according to Claim 1, **characterized in that** the battery comprises a plurality of modules (26) with associated module control units (24) and the histogram (2, 12) and a further check sum are stored in a non-volatile memory (18) of at least one module control unit (24).

3. Method for providing information for maintenance and servicing purposes for a battery according to Claim 1, wherein the battery comprises at least one battery module (26) with an associated module control unit (24) and a central control unit (22), wherein at least one module control unit (24) comprises a non-volatile memory (18), with the following additional steps, wherein, in step c), the determination of the check sum is performed by means of the central control unit using the histogram (2, 12) and the individual key of the module control unit (24), and, in step d), the storage (S5) of the histogram (2, 12) and of the check sum is performed in the non-volatile memory (18) of the module control unit (24):
e) Transmitting the histogram (2, 12) and the check sum from the central control unit (22) to the module control unit (24);
f) Authentication of the histogram (2, 12) using the check sum by the module control unit (24);

4. Method according to Claim 3, **characterized in that** for performing step d) an existing histogram is loaded (S1) from the non-volatile memory (18) of the module control unit (24), the histogram received and authenticated by the central control unit (22) and the existing histogram are suitably combined to form an updated histogram and are stored (S5) in the non-volatile memory (18).

5. Method according to Claim 4, **characterized in that** in the event of a failure of authentication an error message or a counter is transmitted from the module control unit (24) to the central control unit (22).

6. Data structure with at least one histogram (2, 12) comprising frequency values (6) of the occurrence of certain values (7, 8) of quantized usage data or values derived therefrom, and with at least one check sum, wherein the data structure has been produced during the performance of one of the methods according to any one of Claims 1 to 5.

7. Computer program for performing one of the methods according to any one of Claims 1 to 5 if the computer program is implemented on a programmable computer device.

8. Battery management system (20) with a unit (15) for recording and quantization of usage data of a battery unit (28), a control unit, a unit (14) for producing a histogram (2, 12) comprising frequency values (6) of the occurrence of certain values (7, 8) of the individual quantized usage data or values derived therefrom, a unit (17) for determining a check sum using the histogram (2, 12) and an individual key of the control unit (22, 24), wherein the check sum is calculated by means of a one-way function, in particular a cyclic redundancy check, or by using a hash function, and a unit for storing the histogram (2, 12) and the check sum in a non-volatile memory (18).

9. Battery comprising a plurality of battery cells and a battery management system (20) according to Claim 8 and able to be connected to a drive system of a motor vehicle.

10. Motor vehicle with a battery according to Claim 9, wherein the battery is connected to a drive system of the motor vehicle.

## Revendications

1. Procédé de fourniture d'informations à des fins de maintenance et d'entretien d'une batterie, laquelle possède un contrôleur (22, 24) doté d'une mémoire non volatile (18) et de plusieurs unités de batterie (28), comprenant les étapes suivantes :
a) acquisition et quantification de données utiles des unités de batterie (28) ;
b) formation d'un histogramme (2, 12) qui présente des valeurs de fréquence (6) de l'occurrence de certaines valeurs (7, 8) des données utiles quantifiées individuelles ou de valeurs qui en sont dérivées ;
c) détermination d'une somme de contrôle qui est déterminée à l'aide de l'histogramme (2, 12) et d'une clé individuelle du contrôleur (22, 24), la somme de contrôle étant calculée au moyen d'une fonction unidirectionnelle, notamment d'un contrôle de redondance cyclique ou d'une utilisation d'une fonction de hachage, et
d) mémorisation (S5) de l'histogramme (2, 12) et de la somme de contrôle dans la mémoire non volatile (18) du contrôleur (22, 24).

2. Procédé selon la revendication 1, **caractérisé en ce que** la batterie possède plusieurs modules (26) dotés de contrôleurs de module (24) associés et l'histogramme (2, 12) ainsi qu'une somme de contrôle supplémentaire sont mémorisés dans une mémoire non volatile (18) d'au moins un contrôleur de module (24).

3. Procédé de fourniture d'informations à des fins de maintenance et d'entretien d'une batterie selon la revendication 1, la batterie comportant au moins un module de batterie (26) doté d'un contrôleur de module (24) associé et un contrôleur central (22), au moins un contrôleur de module (24) possédant une mémoire non volatile (18), comprenant les étapes supplémentaires suivantes, à l'étape c), la détermination de la somme de contrôle étant effectuée par le contrôleur central à l'aide de l'histogramme (2, 12) et de la clé individuelle du contrôleur de module (24) et, à l'étape d), la mémorisation (S5) de l'histogramme (2, 12) et de la somme de contrôle étant effectuée dans la mémoire non volatile (18) du contrôleur de module (24) ;
e) communication de l'histogramme (2, 12) et de la somme de contrôle du contrôleur central (22) au contrôleur de module (24) ;
f) authentification de l'histogramme (2, 12) à l'aide de la somme de contrôle par le contrôleur de module (24).

4. Procédé selon la revendication 3, **caractérisé en ce qu'**en vue de la mise en œuvre de l'étape d), un histogramme existant est chargé (S1) depuis la mémoire non volatile (18) du contrôleur de module (24), l'histogramme reçu et authentifié par le contrôleur central (22) et l'histogramme existant sont fusionnés en un histogramme actualisé et sont mémorisés (S5) dans la mémoire non volatile (18).

5. Procédé selon la revendication 4, **caractérisé en ce que** dans le cas d'un échec d'une authentification, un message d'erreur ou un compteur est communiqué du contrôleur de module (24) au contrôleur central (22).

6. Structure de données comprenant au moins un histogramme (2, 12), qui présente des valeurs de fréquence (6) de l'occurrence de certaines valeurs (7, 8) de données utiles quantifiées individuelles ou de valeurs qui en sont dérivées, et comprenant au moins une somme de contrôle, la structure de données ayant été créée lors de la mise en œuvre d'un des procédés selon l'une des revendications 1 à 5.

7. Programme informatique destiné à mettre en œuvre un des procédés selon l'une des revendications 1 à 5 lorsque le programme informatique est exécuté sur un dispositif informatique programmable.

8. Système de gestion de batterie (20), comprenant une unité (15) destinée à acquérir et à quantifier des données utiles d'une unité de batterie (28), un contrôleur, une unité (14) destinée à créer un histogramme (2, 12) qui présente des valeurs de fréquence (6) de l'occurrence de certaines valeurs (7, 8) des données utiles quantifiées individuelles ou de valeurs qui en sont dérivées, une unité (17) destinée à déterminer une somme de contrôle qui est déterminée à l'aide de l'histogramme (2, 12) et d'une clé individuelle du contrôleur (22, 24), la somme de contrôle étant calculée au moyen d'une fonction unidirectionnelle, notamment d'un contrôle de redondance cyclique ou d'une utilisation d'une fonction de hachage, et à une unité destinée à mémoriser l'histogramme (2, 12) et de la somme de contrôle dans une mémoire non volatile (18).

9. Batterie, qui comporte plusieurs cellules de batterie et un système de gestion de batterie (20) selon la revendication 8, et qui peut être connectée à un système de propulsion d'un véhicule automobile.

10. Véhicule automobile équipé d'une batterie selon la revendication 9, la batterie étant connectée à un système de propulsion du véhicule automobile.
